# EUROPÄISCHE PATENTSCHRIFT

(11) **EP 2 619 809 B1**
(45) Veröffentlichungstag und Bekanntmachung des Hinweises auf die Patenterteilung: **18.07.2018**
(21) Anmeldenummer: 11760480.1
(22) Anmeldetag: 21.09.2011
(51) Int. Cl.: H01L 33/52, H01L 25/075, H01L 25/16, H01L 33/62, H01L 33/56, H01L 33/60, H01L 23/00, H01L 33/54

(54) **OPTOELEKTRONISCHES HALBLEITERBAUELEMENT**
OPTOELECTRONIC SEMICONDUCTOR DEVICE
COMPOSANT SEMI-CONDUCTEUR OPTOÉLECTRONIQUE

(30) Priorität: 22.09.2010 DE 102010046254
(43) Veröffentlichungstag der Anmeldung: 31.07.2013
(73) Patentinhaber: OSRAM Opto Semiconductors GmbH, 93055 Regensburg (DE)
(72) Erfinder: SCHNEIDER, Markus, 93152 Schönhofen (DE); RAMCHEN, Johann, 84032 Altdorf (DE); WITTMANN, Michael, 93087 Alteglofsheim (DE)
(74) Vertreter: Epping - Hermann - Fischer
(86) Internationale Anmeldenummer: PCT/EP2011/066458
(87) Internationale Veröffentlichungsnummer: WO 2012/038483

(56) Entgegenhaltungen:
- EP-A1- 0 147 514
- EP-A1- 0 147 514
- EP-A1- 2 144 305
- EP-A2- 0 374 121
- WO-A1-2010/035206
- WO-A1-2010/035206
- WO-A2-2009/075753
- DE-A1-102007 029 369
- DE-A1-102007 030 129
- DE-A1-102008 021 402
- JP-A- 2010 157 638
- JP-A- 2010 157 638

## Beschreibung

Es wird ein optoelektronisches Halbleiterbauelement angegeben.

Die EP 147 514 beschreibt ein strahlungsemittierendes Halbleiterbauelement mit einer strahlungsabsorbierenden Schicht, die das Halbleiterbauelement umrandet.

Die JP 2010 157638 beschreibt ein strahlungsemittierendes Bauelement, mit einer reflektierenden Schicht und einer lichtabsorbierenden Schicht.

Eine zu lösende Aufgabe besteht darin, ein optoelektronisches Halbleiterbauelement anzugeben, welches schwarz erscheint.

Gemäß zumindest einer Ausführungsform des optoelektronischen Halbleiterbauelements umfasst dieses einen Träger, der eine Oberseite und eine der Oberseite gegenüberliegende Unterseite aufweist. Bei dem Träger kann es sich um eine Leiterplatte oder einen metallischen Trägerrahmen (lead frame) handeln. Ebenso ist denkbar, dass der Träger flexibel und beispielsweise als Folie ausgebildet ist. Der Träger kann mit einem elektrisch leitenden Material, beispielsweise einem Metall und/oder einem elektrisch isolierenden Material, beispielsweise einem duro- und/oder thermoplastischen Material und/oder einem keramischen Material, gebildet sein.

An der Oberseite und der Unterseite ist jeweils eine Fläche ausgebildet, die durch einen Teil der Außenflächen des Trägers gebildet ist. Die Fläche an der Unterseite ist der Teil der Außenflächen des Trägers, die einem Kontaktträger - beispielsweise einer Leiterplatte - im montierten Zustand des Trägers zugewandt ist. Zum Beispiel ist die Fläche an der Unterseite des Trägers eine Montagefläche, die zur Montage des optoelektronischen Halbleiterbauelements dienen kann.

Gemäß zumindest einer Ausführungsform umfasst das optoelektronische Halbleiterbauelement zumindest ein an der Oberseite angeordnetes strahlungsemittierendes Halbleiterbauteil mit einer Strahlungsaustrittsfläche, durch die zumindest ein Teil der im Betrieb des Halbleiterbauteils erzeugten elektromagnetischen Strahlung das Halbleiterbauteil verlässt. Bei dem strahlungsemittierenden Halbleiterbauteil kann es sich um einen strahlungsemittierenden Halbleiterchip handeln. Beispielsweise handelt es sich bei dem Halbleiterchip um einen Lumineszenzdiodenchip. Bei dem Lumineszenzdiodenchip kann es sich um einen Leuchtdiodenchip oder um einen Laserdiodenchip handeln.

Gemäß zumindest einer Ausführungsform umfasst das optoelektronische Halbleiterbauelement eine strahlungsabsorbierende Schicht, die dazu eingerichtet ist, auf das Bauelement auftreffendes Umgebungslicht derart zu absorbieren, dass eine dem Träger abgewandte Außenfläche des Bauelements zumindest stellenweise schwarz erscheint. Zum Beispiel sind dazu in die strahlungsabsorbierende Schicht strahlungsabsorbierende Teilchen oder Fasern, wie zum Beispiel Rußpartikel oder andere strahlungsabsorbierende Partikel, eingebracht. Zum Beispiel ist die dem Träger abgewandte Außenfläche des Bauelements zumindest stellenweise durch die strahlungsabsorbierende Schicht selbst gebildet.

Gemäß zumindest einer Ausführungsform umrandet die strahlungsabsorbierende Schicht das strahlungsemittierende Halbleiterbauteil in lateraler Richtung vollständig und ist mit Seitenflächen des strahlungsemittierenden Halbleiterbauteils zumindest stellenweise in direktem Kontakt. In "lateraler Richtung" bedeutet hierbei eine Richtung parallel zur Haupterstreckungsrichtung des Trägers. Beispielsweise erscheint in einer Draufsicht auf die Außenfläche des Halbleiterbauelements die Außenfläche bis auf die Strahlungsaustrittsfläche schwarz.

Gemäß zumindest einer Ausführungsform ist die Strahlungsaustrittsfläche frei von der strahlungsabsorbierenden Schicht. "Frei" heißt, dass die Strahlungsaustrittsfläche weder von der strahlungsabsorbierenden Schicht bedeckt ist noch die strahlungsabsorbierende Schicht beispielsweise entlang eines Strahlungsaustrittsweges des strahlungsemittierenden Halbleiterbauteils dem Halbleiterbauteil nachgeordnet ist. Es ist höchstens möglich, dass herstellungsbedingt sich noch Materialreste der strahlungsabsorbierenden Schicht auf der Strahlungsaustrittsfläche befinden, die die Strahlungsaustrittsfläche jedoch zu höchstens 10 %, bevorzugt zu höchstens 5 % bedecken.

Gemäß zumindest einer Ausführungsform umfasst das optoelektronische Halbleiterbauelement einen Träger, der eine Oberseite und einer der Oberseite gegenüberliegende Unterseite aufweist. An der Oberseite ist zumindest ein strahlungsemittierendes Halbleiterbauteil mit einer Strahlungsaustrittsfläche angeordnet, durch die zumindest ein Teil der im Betrieb des Halbleiterbauteils erzeugten elektromagnetischen Strahlung das Halbleiterbauteil verlässt. Weiter umfasst das optoelektronische Halbleiterbauelement eine strahlungsabsorbierende Schicht, die dazu eingerichtet ist, auf das Bauelement auftreffendes Umgebungslicht derart zu absorbieren, dass eine dem Träger abgewandte Außenfläche des Bauelements zumindest stellenweise schwarz erscheint. Die strahlungsabsorbierende Schicht umrandet das strahlungsemittierende Halbleiterbauteil in lateraler Richtung vollständig und ist mit Seitenflächen des strahlungsemittierenden Halbleiterbauteils zumindest stellenweise in direktem Kontakt. Weiter ist die Strahlungsaustrittsfläche frei von der strahlungsabsorbierenden Schicht.

Das hier beschriebene optoelektronische Halbleiterbauelement zeichnet sich durch einen hohen Helligkeitskontrast zwischen der Strahlungsaustrittsfläche und dem Rest der Außenfläche des Bauelements aus und ist daher für den Einsatz zum Beispiel in Anzeigevorrichtungen besonders geeignet. Ferner können störende Rückreflexionen elektromagnetischer Strahlung von beispielsweise im Bauelement verbauten Optiken zurück in Richtung des strahlungsemittierenden Halbleiterbauteils des Bauelements vermieden werden.

Gemäß zumindest einer Ausführungsform ist die Außenfläche des Halbleiterbauelements zumindest stellenweise durch die Außenfläche der strahlungsabsorbierenden Schicht gebildet. Die strahlungsabsorbierende Schicht begrenzt das Halbleiterbauelement nach außen und ist insbesondere nicht in einer Kavität eines Gehäuses angeordnet und bildet insbesondere selbst einen Teil des Gehäuses aus. Dabei können die Seitenflächen der strahlungsabsorbierenden Schicht bündig mit den Seitenflächen des Trägers abschließen, wobei die strahlungsabsorbierenden Schicht auch die dem Träger abgewandte Oberfläche des Halbleiterbauelements ausbilden kann.

Gemäß zumindest einer Ausführungsform ist die strahlungsabsorbierende Schicht ein Verguss, der die Seitenflächen des Halbleiterbauelements zumindest stellenweise formschlüssig umhüllt. "Formschlüssig" heißt in diesem Zusammenhang, dass sich zwischen der strahlungsabsorbierenden Schicht und den Seitenflächen des Halbleiterbauteils weder ein Spalt noch eine Unterbrechung ausbildet. Vorzugsweise sind die strahlungsabsorbierende Schicht und die Seitenflächen in direktem Kontakt miteinander. Beispielsweise ist die strahlungsabsorbierende Schicht mittels Vergießens des Halbleiterbauteils und anschließendem Aushärten auf dem Träger aufgebracht. "Zumindest stellenweise" kann dabei bedeuten, dass die strahlungsabsorbierende Schicht die Seitenflächen des Halbleiterbauteils nur bis zu einer gewissen Füllhöhe formschlüssig umhüllt. Dadurch ist es möglich, dass das Halbleiterbauteil selbst an seinen Seitenflächen durch die strahlungsabsorbierende Schicht vollständig verdeckt ist. Es sind also die Seitenflächen des Halbleiterbauteils vollständig oder bis zu einer vorgebbaren Höhe teilweise von der strahlungsabsorbierenden Schicht bedeckt.

Gemäß zumindest einer Ausführungsform überragt die strahlungsabsorbierende Schicht das Halbleiterbauteil in vertikaler Richtung nicht. "In vertikaler Richtung" heißt eine Richtung senkrecht zur lateralen Richtung. Beispielsweise schließt die strahlungsabsorbierende Schicht in lateraler Richtung bündig mit der Strahlungsaustrittsfläche des Halbleiterbauteils ab. Beispielsweise ist dann die Außenfläche des Halbleiterbauteils durch eine dem Träger abgewandte Außenfläche der strahlungsabsorbierenden Schicht und die Strahlungsaustrittsfläche des Halbleiterbauteils gebildet. Zum Beispiel ist das strahlungsemittierende Halbleiterbauteil mit einem strahlungsemittierenden Halbleiterchip und einem dem Halbleiterchip in seiner Hauptabstrahlrichtung nachgeordneten Konversionselement gebildet. Das Konversionselement kann zur zumindest teilweisen Konversion von vom strahlungsemittierenden Halbleiterchip emittierter elektromagnetischer Strahlung in elektromagnetische Strahlung eines anderen Wellenlängenbereichs dienen. In diesem Fall kann die Strahlungsaustrittsfläche durch eine dem Träger abgewandte Außenfläche des Konversionselements gebildet sein.

Gemäß zumindest einer Ausführungsform ist in vertikaler Richtung zwischen dem Träger und der strahlungsabsorbierenden Schicht eine strahlungsreflektierende Schicht angeordnet, welche die Seitenflächen des Halbleiterbauteils stellenweise bedeckt. "Strahlungsreflektierend" heißt insbesondere, dass die strahlungsreflektierende Schicht zumindest zu 80 %, bevorzugt zu mehr als 90 %, reflektierend für auf sie auftreffendes Licht ist. Beispielsweise erscheint für einen externen Betrachter der strahlungsreflektierenden Schicht die strahlungsreflektierende Schicht weiß. Beispielsweise sind dazu in die strahlungsreflektierende Schicht strahlungsreflektierende Partikel eingebracht, die zum Beispiel mit zumindest einem der Materialien TiO₂, BaSo₄, ZnO oder AlₓO_{y} gebildet sind oder zumindest eines der genannten Materialien enthalten. In einer Draufsicht auf die Außenfläche des Halbleiterbauelements ist die reflektierende Schicht vollständig durch die strahlungsabsorbierende Schicht verdeckt. Mit anderen Worten ist für einen externen Betrachter die strahlungsreflektierende Schicht in einer Draufsicht auf die Außenfläche des Halbleiterbauelements nicht mehr erkennbar und/oder wahrnehmbar. Vorteilhaft wird innerhalb des Halbleiterbauteils erzeugte und über die Seitenflächen austretende elektromagnetische Strahlung zumindest teilweise durch die strahlungsreflektierende Schicht in das Halbleiterbauteil zurück reflektiert und beispielsweise in Richtung der Strahlungsaustrittsfläche gelenkt. Es wird daher ein möglichst großer Anteil der innerhalb des Halbleiterbauteils erzeugten elektromagnetischen Strahlung in Richtung der Strahlungsaustrittsfläche reflektiert und kann dann aus dem Halbleiterbauelement über die Strahlungsaustrittsfläche des Halbleiterbauteils auskoppeln. Mit anderen Worten werden die reflektierenden Eigenschaften der strahlungsreflektierenden Schicht mit den kontrasterzeugenden Eigenschaften der strahlungsabsorbierenden Schicht in einem Halbleiterbauelement kombiniert, um zum einen möglichst viel elektromagnetische Strahlung aus dem Bauelement auskoppeln zu können und zum anderen den Kontrast zu erhöhen.

Gemäß zumindest einer Ausführungsform treten zumindest 20 % der insgesamt von dem Halbleiterbauteil emittierten elektromagnetischen Strahlung durch die Seitenflächen aus dem Halbleiterbauteil aus und werden durch die strahlungsreflektierende Schicht zumindest teilweise reflektiert. Bei dem Halbleiterbauteil handelt es sich also um einen so genannten Volumenemitter, aus dem von ihm erzeugte elektromagnetische Strahlung nicht nur über seine dem Träger abgewandte Hauptfläche, sondern zusätzlich zumindest teilweise über seine Seitenflächen austritt. Überraschend hat sich gezeigt, dass, obwohl das Halbleiterbauteil ebenso über seine Seitenflächen elektromagnetische Strahlung emittiert, mittels der hier beschriebenen strahlungsreflektierenden Schicht eine Strahlungsauskoppeleffizienz besonders effektiv gesteigert werden kann. "Strahlungsauskoppeleffizienz" ist dabei das Verhältnis von aus dem Halbleiterbauelement über seine Strahlungsaustrittsfläche ausgekoppelter Leuchtenergie zu primär innerhalb des Halbleiterbauteils erzeugter Leuchtenergie Gemäß zumindest einer Ausführungsform wird auf eine dem Träger abgewandte Außenfläche der strahlungsabsorbierenden Schicht und/oder auf die Strahlungsaustrittsfläche zumindest stellenweise eine strahlungsdurchlässige Schicht aufgebracht. "Strahlungsdurchlässig" heißt in diesem Zusammenhang, dass die Schicht zumindest zu 80 %, bevorzugt zu mehr als 90 % durchlässig für auf die auftreffende elektromagnetische Strahlung ist. In diesem Fall kann die Außenfläche des Halbleiterbauelements durch eine dem Träger abgewandte Außenfläche der strahlungsdurchlässigen Schicht zumindest stellenweise gebildet sein. Bei einer Draufsicht auf die Außenfläche des Halbleiterbauelements sind von außen beispielsweise nur die strahlungsabsorbierende Schicht und/oder die Strahlungsaustrittsfläche des Halbleiterbauteils erkennbar. Mit anderen Worten erscheint die Außenfläche der strahlungsdurchlässigen Schicht für den externen Betrachter aufgrund der darunter liegenden strahlungsabsorbierenden Schicht zumindest stellenweise schwarz. Zum Beispiel ist die strahlungsdurchlässige Schicht mit einem Silikon gebildet, welches zumindest teilweise oxidiert ist (auch Verglasung). Zum Beispiel ist die Außenfläche der strahlungsdurchlässigen Schicht zumindest teilweise oxidiert. Vorteilhaft kann durch das zumindest teilweise Oxidieren der strahlungsdurchlässigen Schicht eine Klebrigkeit der Außenfläche der strahlungsdurchlässigen Schicht verringert werden. Beispielsweise kann so vermieden werden, dass unerwünschte Fremdpartikel, wie zum Beispiel Staubpartikel, an der Außenfläche der strahlungsdurchlässigen Schicht haften und/oder kleben bleiben.

Gemäß zumindest einer Ausführungsform weist der Träger des optoelektronischen Halbleiterbauelements zumindest eine Anschlussstelle auf. Zum Beispiel bildet die Anschlussstelle stellenweise die Fläche an der Oberseite des Trägers aus.

Gemäß zumindest einer Ausführungsform umfasst das optoelektronische Halbleiterbauelement zumindest eine über zumindest einer der Anschlussstellen des Trägers angeordnete Schichtöffnung, welche die strahlungsabsorbierende Schicht vollständig durchdringt und sich von einer dem Träger abgewandten Oberseite der strahlungsabsorbierenden Schicht in Richtung der Unterseite des Trägers erstreckt. Beispielsweise weist die Schichtöffnung zumindest eine Seitenfläche auf. Die zumindest eine Seitenfläche der Öffnung ist zumindest stellenweise durch die strahlungsabsorbierende Schicht gebildet. "Über" heißt in diesem Zusammenhang, dass die Anschlussstelle und die Schichtöffnung in vertikaler Richtung zumindest stellenweise überlappen. An Stellen, an denen die Anschlussstelle mit der Schichtöffnung überlappt, ist die Anschlussstelle zumindest stellenweise frei von dem Material der strahlungsabsorbierenden Schicht. Beispielsweise ist die Anschlussstelle über die Schichtöffnung in der strahlungsabsorbierenden Schicht von außen elektrisch kontaktierbar.

Gemäß zumindest einer Ausführungsform ist in der Schichtöffnung zumindest stellenweise ein elektrisch leitendes Material angeordnet. Das elektrisch leitende Material ist beispielsweise mit einem Metall oder einem elektrisch leitfähigen Klebstoff gebildet. Beispielsweise füllt das elektrisch leitende Material die Schichtöffnung vollständig aus.

Gemäß zumindest einer Ausführungsform ist das elektrisch leitende Material zumindest stellenweise auf der dem Träger abgewandten Außenfläche des Bauelements angeordnet. Bildet beispielsweise die dem Träger abgewandte Außenfläche der strahlungsabsorbierenden Schicht selbst zumindest stellenweise die Außenfläche des Bauelements aus, kann das elektrisch leitende Material auf der Außenfläche der strahlungsabsorbierenden Schicht zumindest stellenweise angeordnet sein und mit dieser an diesen Stellen in direktem Kontakt stehen. Entsprechendes gilt für den Fall, dass die dem Träger abgewandte Außenfläche der strahlungsdurchlässigen Schicht zumindest stellenweise die Außenfläche des Bauelements bildet.

Gemäß zumindest einer Ausführungsform verbindet das elektrisch leitende Material die Anschlussstelle elektrisch leitend mit dem Halbleiterbauteil. Das heißt, das elektrisch leitende Material verbindet das Halbleiterbauteil mit der Schichtöffnung und verläuft dabei in lateraler Richtung zwischen dem Halbleiterbauteil und der Schichtöffnung zumindest stellenweise auf der Außenfläche des Bauelements.

Gemäß zumindest einer Ausführungsform ist zumindest eine leitende Verbindung zwischen der Anschlussstelle und einer weiteren Anschlussstelle an der Oberseite des Trägers mit Kontaktflächen an der der Oberseite gegenüberliegende Unterseite des Trägers mittels einer Durchkontaktierung hergestellt. Dabei erstreckt sich die Durchkontaktierung durch den Träger hindurch und ist seitlich vom Träger umgeben. Mittels der Kontaktflächen an der Unterseite des Trägers kann das optoelektronische Halbleiterbauelement zum Beispiel mittels Oberflächenmontagetechnik (auch SMT) montierbar sein.

Gemäß zumindest einer Ausführungsform durchdringt die Schichtöffnung zusätzlich die strahlungsreflektierende Schicht und/oder die strahlungsdurchlässige Schicht vollständig. In diesem Fall ist die zumindest eine Seitenfläche der Schichtöffnung zusätzlich stellenweise durch die strahlungsabsorbierende Schicht oder die strahlungsreflektierende Schicht gebildet.

Gemäß zumindest einer Ausführungsform umfasst das optoelektronische Halbleiterbauelement zumindest zwei an der Oberseite des Trägers in lateraler Richtung nebeneinander angeordnete strahlungsemittierende Halbleiterbauteile, wobei zumindest zwei der strahlungsemittierenden Halbleiterbauteile Licht unterschiedlicher Farbe emittieren. Beispielsweise umfasst das optoelektronische Halbleiterbauelement ein strahlungsemittierendes Halbleiterbauteil, welches blaues Licht und eines, welches gelbes Licht emittiert. Ebenso sind je nach den an das optoelektronische Halbleiterbauelement angelegten Beleuchtungsanforderungen beliebig andere Kombinationen von strahlungsemittierenden Halbleiterbauelementen denkbar, welche Licht unterschiedlicher Farben emittieren können. Vorteilhaft können verschiedenfarbig emittierende Halbleiterbauelemente in einer variablen Anordnung zueinander platzsparend und kompakt auf einem gemeinsamen Träger angeordnet sein.

Gemäß zumindest einer Ausführungsform ist eine Bonddrahtkontaktierung des Halbleiterbauteils zumindest stellenweise von der strahlungsabsorbierenden Schicht bedeckt. Die Bonddrahtkontaktierung verbindet die Anschlussstelle mit dem Halbleiterbauteil, beispielsweise mittels eines Bonddrahts, elektrisch. Beispielsweise ist die Bonddrahtkontaktierung vollständig von der strahlungsabsorbierenden Schicht bedeckt. Mit anderen Worten verläuft dann die Bonddrahtkontaktierung vollständig innerhalb der strahlungsabsorbierenden Schicht. In diesem Fall ragt der Bonddraht der Bonddrahtkontaktierung nicht aus dem Halbleiterbauteil hervor.

Gemäß zumindest einer Ausführungsform grenzt das elektrisch leitende Material stellenweise direkt an die strahlungsabsorbierende Schicht an. Zum Beispiel verläuft das elektrisch leitende Material dabei stellenweise an der dem Träger abgewandten Außenfläche der strahlungsabsorbierende Schicht und bedeckt diese dort teilweise. Dabei ist es insbesondere möglich, dass das elektrisch leitende Material mit einem strahlungsdurchlässigen Material, beispielsweise einem TCO (Transparent Conductive Oxide), gebildet ist. Als strahlungsdurchlässige Materialien kommen dabei unter anderem ITO oder ZNO in Frage. Aufgrund der Verwendung von einem strahlungsdurchlässigen Material für das elektrisch leitende Material ist die strahlungsabsorbierende Wirkung der strahlungsabsorbierenden Schicht nicht reduziert.

Gemäß zumindest einer Ausführungsform ist das elektrisch leitende Material strahlungsdurchlässig, insbesondere klarsichtig und transparent.

Im Folgenden wird das hier beschriebene optoelektronische Halbleiterbauelement anhand von Ausführungsbeispielen und den dazugehörigen Figuren näher erläutert.

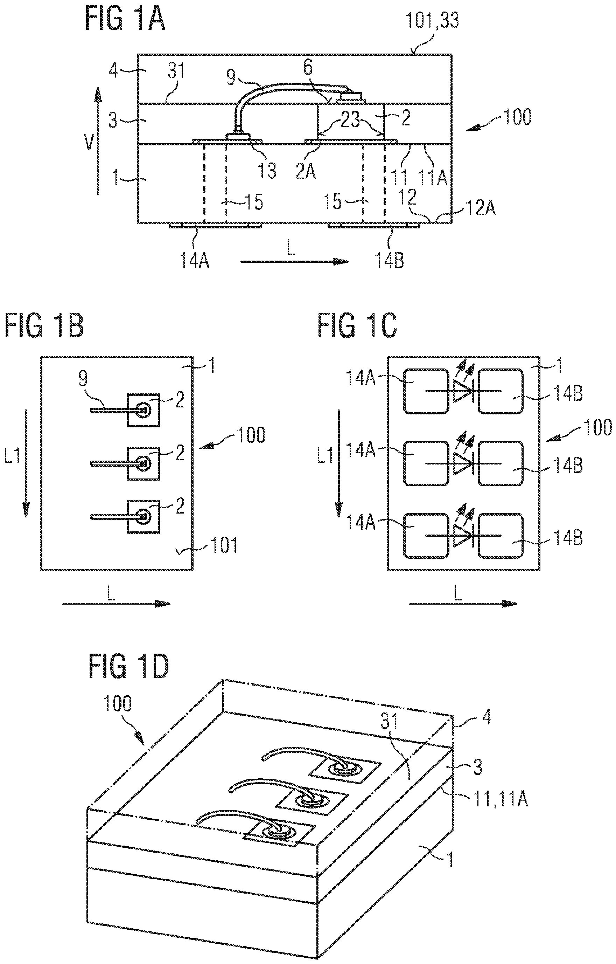

Die Figuren 1A, 1B, 1C, 1D, 2A, 2B, 2C, 2D, 2E, 3A, 3B, 3C, 3D, 4A und 4B zeigen in schematischen Ansichten verschiedene Ausführungsbeispiele eines hier beschriebenen optoelektronischen Halbleiterbauelements.

In den Ausführungsbeispielen und in den Figuren sind gleiche oder gleich wirkende Bestandteile jeweils mit den gleichen Bezugszeichen versehen. Die dargestellten Elemente sind nicht als maßstabsgetreu anzusehen, vielmehr können einzelne Elemente zum besseren Verständnis verschieden groß dargestellt sein.

Die Figur 1A zeigt in einer schematischen Schnittdarstellung ein Ausführungsbeispiel eines hier beschriebenen optoelektronischen Halbleiterbauelements 100. Ein Träger 1 des Halbleiterbauelements 100 weist eine Oberseite 11 sowie eine der Oberseite 11 gegenüberliegende Unterseite 12 auf. Zum Beispiel ist der Träger 1 mit einem Kunststoffmaterial und/oder einem keramischen Material gebildet. Ferner weist der Träger 1 Anschlussstellen 13 an seiner Oberseite 11 auf. Auf in lateraler Richtung L jeweils neben den Anschlussstellen 13 angeordnete Anschlussstellen 2A des Trägers 1 sind in Form einer Reihe in einer Querrichtung L1 (siehe Figur 1B und 1C) strahlungsemittierende Halbleiterbauteile 2 mit jeweils einer von zwei, sich jeweils gegenüberliegenden, Hauptflächen eines Halbleiterbauteils 2, aufgebracht. Die Querrichtung L1 verläuft dabei parallel zu einer Haupterstreckungsrichtung des Trägers 1 und quer zur lateralen Richtung L. Jedes strahlungsemittierende Halbleiterbauteil 2 ist mittels einer Bonddrahtkontaktierung 9 mit einer dem strahlungsemittierenden Halbleiterbauteil 2 zugeordneten Anschlussstelle 13 elektrisch kontaktiert. Ferner weist der Träger 1 an seiner Unterseite 12 in lateraler Richtung L nebeneinander angeordnete Kontaktflächen 14A und 14B auf. Eine elektrisch leitende Verbindung zwischen den Kontaktflächen 14A, 14B und den Anschlussstellen 13, 2A an der Oberseite 11 des Trägers 1 ist mittels Durchkontaktierungen 15 hergestellt. Mit anderen Worten erstreckt sich die Durchkontaktierung 15 ausgehend von der Oberseite 11 des Trägers 1 durchgehend in Richtung der Unterseite 12 des Trägers 1.

Dabei dient die Kontaktfläche 14A zur elektrischen Kontaktierung einer ihr jeweils zugeordneten Anschlussstelle 13 und die Kontaktfläche 14B zur elektrischen Kontaktierung einer ihr jeweils zugeordneten Anschlussstelle 2A. Ist der Träger 1 mit seinen Kontaktflächen 14A, 14B auf einem Kontaktträger aufgebracht, kann das optoelektronische Halbleiterbauelement 100 über die Kontaktflächen 14A, 14B elektrisch kontaktiert werden. Das optoelektronische Halbleiterbauelement 100 ist dann oberflächenmontierbar.

Weiter weist jedes strahlungsemittierende Halbleiterbauteil 2 eine Strahlungsaustrittsfläche 6 auf, durch die zumindest ein Teil der im Betrieb des strahlungsemittierenden Halbleiterbauteils 2 erzeugten elektromagnetischen Strahlung das Halbleiterbauteil 2 verlässt. Die Strahlungsaustrittsfläche 6 ist die dem Träger 1 abgewandte Hauptfläche des strahlungsemittierenden Halbleiterbauteils 2. Seitenflächen 23 des strahlungsemittierenden Halbleiterbauteils 2 verbinden die beiden Hauptflächen miteinander und verlaufen quer oder im Wesentlichen quer zu den beiden Hauptflächen.

Weiter umfasst das optoelektronische Halbleiterbauelement 100 eine strahlungsabsorbierende Schicht 3, die die Seitenflächen 23 des Halbleiterbauteils 2 vollständig und formschlüssig bedeckt. Vorliegend handelt es sich bei der strahlungsabsorbierenden Schicht 3 um einen Verguss, der beispielsweise mittels Vergießens des Halbleiterbauteils 2 auf eine Fläche 11A an der Oberseite 11 des Trägers 1 aufgebracht ist. Dabei ist die Strahlungsaustrittsfläche 6 frei von der strahlungsabsorbierenden Schicht 3, wobei die strahlungsabsorbierende Schicht 3 das strahlungsemittierende Halbleiterbauteil 2 in lateraler Richtung L vollständig umrandet. Die strahlungsabsorbierende Schicht 3 kann mit einem Matrixmaterial gebildet sein, in das strahlungsabsorbierende Partikel, zum Beispiel Rußpartikel, eingebracht sind. Die strahlungsabsorbierende Schicht erscheint daher schwarz. Zum Beispiel handelt es sich bei dem Matrixmaterial um ein Silikon, ein Epoxid oder eine Mischung aus Silikon und Epoxid.

Weiter überragt die strahlungsabsorbierende Schicht 3 das Halbleiterbauteil 2 in vertikaler Richtung V nicht. Mit anderen Worten schließt die strahlungsabsorbierende Schicht 3 in lateraler Richtung L bündig mit der Strahlungsaustrittsfläche 6 des Halbleiterbauteils 2 ab.

Auf einer dem Träger 1 abgewandten Außenfläche 31 der strahlungsabsorbierenden Schicht 3 und auf die Strahlungsaustrittsfläche 6 ist vollständig eine strahlungsdurchlässige Schicht 4 aufgebracht. Beispielsweise ist die strahlungsdurchlässige Schicht 4 mit einem Matrixmaterial wie einem Silikon, einem Epoxid oder eine Mischung aus Silikon und Epoxid gebildet. Eine Außenfläche 101 des optoelektronischen Halbleiterbauelements 100 ist vollständig durch eine dem Träger 1 abgewandte Außenfläche 33 der strahlungsdurchlässigen Schicht 4 gebildet.

Weiter ist aus der Figur 1A erkennbar, dass die Bonddrahtkontaktierung 9 vollständig innerhalb der strahlungsabsorbierenden Schicht 3 und der strahlungsdurchlässigen Schicht 4 verläuft. Mit anderen Worten ragt die Bonddrahtkontaktierung 9 nicht aus dem optoelektronischen Halbleiterbauelement 100 hervor. Ein derartiges Halbleiterbauelement 100 ist daher besonders kompakt und einfach handhabbar.

Die Figur 1B zeigt in einer schematischen Draufsicht auf die Außenfläche 101 des Halbleiterbauelements 100 das in der Figur 1A beschriebene Halbleiterbauelement 100. Erkennbar sind die drei strahlungsemittierenden Halbleiterbauteile 2, welche vorliegend in einer Reihe angeordnet sind. Jedes der strahlungsemittierenden Halbleiterbauteil 2 emittiert Licht unterschiedlicher Farbe. Zum Beispiel emittiert ein strahlungsemittierendes Halbleiterbauteil 2 rotes Licht, eines grünes Licht und ein weiteres blaues Licht.

Die Figur 1C zeigt ein schematisches Schaltbild des in den Figuren 1A und 1B beschriebenen Halbleiterbauelements 100. Erkennbar ist, dass die einzelnen strahlungsemittierenden Halbleiterbauteile 2 jeweils separat kontaktiert und getrennt voneinander über die ihnen zugeordnete Anschlussstelle 13 ansteuerbar sind. Mit anderen Worten kann in jedes strahlungsemittierende Halbleiterbauteil 2 getrennt von den übrigen strahlungsemittierenden Halbleiterbauteilen 2 Strom und/oder eine Betriebsspannung jeweils einer vorgebaren Höhe eingeprägt werden.

Die Figur 1D zeigt in einer schematisch, perspektivischen Ansicht das in den Figuren 1A bis 1C beschriebene optoelektronische Halbleiterbauelement 100. Erkennbar ist wiederum der Träger 1 und die auf die Fläche 11A an der Oberseite 11 des Trägers 1 aufgebrachte strahlungsabsorbierende Schicht 3. Weiter ist aus der Figur 1D die strahlungsdurchlässige Schicht 4 erkennbar, welche vollständig auf die Außenfläche 31 der strahlungsabsorbierenden Schicht 3 und die Strahlungsaustrittsfläche 6 der Halbleiterbauelemente 2 aufgebracht ist.

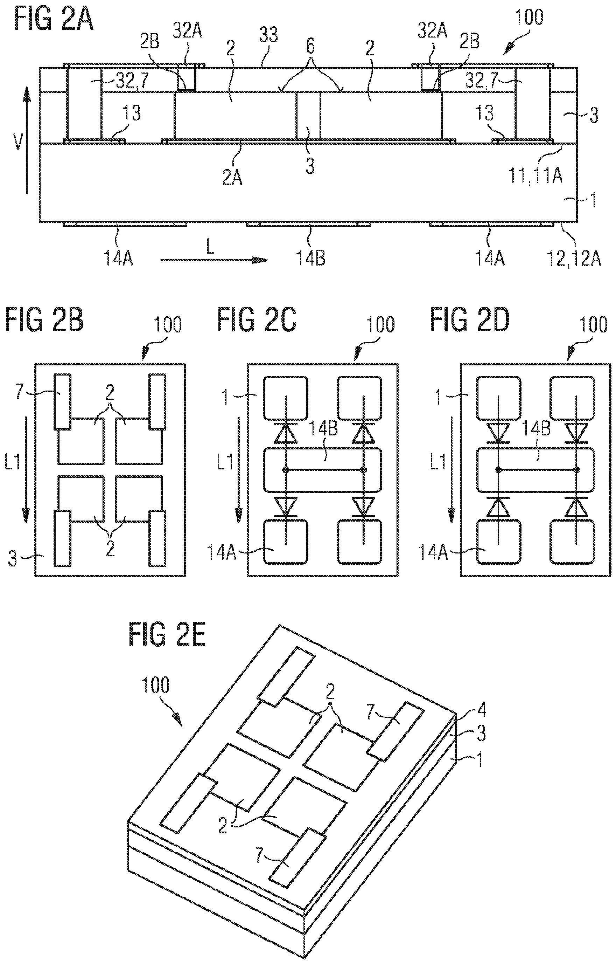

Die Figuren 2A bis 2E zeigen in einer schematischen Ansicht ein weiteres Ausführungsbeispiel eines hier beschriebenen optoelektronischen Halbleiterbauelements 100.

Die Figur 2A zeigt in einer schematischen Schnittdarstellung ein weiteres Ausführungsbeispiel eines hier beschriebenen optoelektronischen Halbleiterbauelements 100. Auf eine wie in den Figuren 1A bis 1D dargestellte Bonddrahtkontaktierung 9 ist bei dem in den Figuren 2A bis 2E dargestellten Ausführungsbeispiel verzichtet. Stattdessen erfolgt eine Kontaktierung der strahlungsemittierenden Halbleiterbauteile 2 wie folgt:
In vertikaler Richtung V über den Anschlussstellen 13 des Trägers 1 ist jeweils eine Schichtöffnung 32 angeordnet, welche sich von der dem Träger 1 abgewandten Außenfläche 33 der strahlungsdurchlässigen Schicht 4 in Richtung der Unterseite 12 des Trägers 1 vollständig sowohl durch die strahlungsdurchlässige Schicht 4 als auch durch die strahlungsabsorbierende Schicht 3 hindurch erstreckt.

Dabei sind die Schichtöffnungen 32 jeweils in lateraler Richtung L beabstandet zu den ihnen zugeordneten strahlungsemittierenden Halbleiterbauteilen 2 angeordnet. In jeder der Schichtöffnungen 32 ist ein elektrisch leitendes Material 7 angeordnet, welches die Schichtöffnungen 32 vollständig ausfüllt. Dabei verläuft das elektrisch leitende Material 7 ausgehend von den Schichtöffnungen 32 auf der Außenfläche 101 des Halbleiterbauelements 100 in Richtung des jeweils einer Schichtöffnung 32 zugeordneten Halbleiterbauteils 2. Das elektrisch leitende Material 7 kontaktiert die strahlungsemittierenden Halbleiterbauteile 2 über in die strahlungsdurchlässige Schicht 4 in vertikaler Richtung V über Kontaktflächen 2B der Halbleiterbauteile 2 eingebrachte weitere Schichtöffnungen 32A elektrisch. Mit anderen Worten verbindet das elektrisch leitende Material 7 die Anschlussstellen 13 elektrisch leitend mit den ihnen zugeordneten Halbleiterbauteilen 2. Dabei ist das elektrisch leitende Material 7 in lateraler Richtung L zwischen den Anschlussstellen 13 und den ihnen zugeordneten strahlungsemittierenden Halbleiterbauteilen 2 direkt und durchgehend auf der Außenfläche 101 angeordnet. Vorteilhaft kann mittels der hier beschriebenen Kontaktierung der Halbleiterbauteile 2 ein minimaler Abstand von in lateraler Richtung L benachbart angeordneten Halbleiterbauteilen 2 realisiert werden. Dies führt zu einem kompakten und platzsparenden optoelektronischen Halbleiterbauelement 100.

In der Figur 2B ist in einer schematischen Draufsicht auf die Außenfläche 101 das in der Figur 2A beschriebene Halbleiterbauelement 100 dargestellt. Das Halbleiterbauelement 100 umfasst insgesamt vier strahlungsemittierende Halbleiterbauteile 2. Weiter ist der Figur 2B entnehmbar, dass die Halbleiterbauteile 2 in Form einer 2 x 2 Matrix, das heißt also in Form von Zeilen und Spalten, angeordnet sind und vorliegend zwei Halbleiterbauteile 2 umfasst, welche grünes Licht emittieren, ein Halbleiterbauteil 2 umfasst, welches rotes Licht emittiert, und ein Halbleiterbauteil umfasst, welches blaues Licht emittiert. Dabei liegen sich die beiden grünes Licht emittierenden Halbleiterbauteile 2 diagonal gegenüber (auch Bayer-Muster). Ebenso sind beliebige andere Anordnungen der Halbleiterbauteile 2 möglich. Denkbar ist, wie in den Figuren 1A bis 1D dargestellt, eine lineare oder eine triangulare Anordnung (falls es sich um drei Halbleiterbauteile 2 handelt). Ebenso können in allen hier beschriebenen Ausführungsformen Halbleiterbauteile 2 verwandt werden, welche alle die gleiche Farbe emittieren.

Die Figuren 2C und 2D zeigen zwei verschiedene schematische Schaltbilder des in den Figuren 2A und 2B dargestellten optoelektronischen Halbleiterbauelements 100. Zu sehen ist, dass das Halbleiterbauelement 100 eine einzige Kontaktfläche 14B und jeweils einem Halbleiterbauteil 2 zugeordnete, also vorliegend insgesamt vier, Kontaktflächen 14A umfasst. Mit anderen Worten bildet die eine einzige Kontaktfläche 14B einen ersten elektrischen Kontakt für alle strahlungsemittierenden Halbleiterbauteile 2 und die vier Kontaktflächen 14A die jeweils anderen elektrischen Kontakte für die strahlungsemittierenden Halbleiterbauteile 2. Dabei ist in der Figur 2C die Kontaktfläche 14B derart verschaltet, dass sie unter externer elektrischer Kontaktierung eine gemeinsame Kathode ausbildet, während in der Figur 2D die Kontaktfläche 14B unter externer Kontaktierung eine gemeinsame Anode für alle strahlungsemittierenden Halbleiterbauteile 2 ausbildet. Das heißt, dass im Unterschied zu dem in den Figuren 1A bis 1D gezeigten Halbleiterbauelement 100 die strahlungsemittierenden Halbleiterbauteile 2 über die eine gemeinsame Kontaktfläche 14B, in Form entweder einer Anode oder einer Kathode, alle gemeinsam elektrisch kontaktiert und ansteuerbar sind.
Die Figur 2E zeigt in einer schematisch, perspektivischen Draufsicht das in den Figuren 2A bis 2D beschriebene optoelektronische Halbleiterbauelement 100. Erkennbar sind wiederum die matrixartig angeordneten optoelektronischen Halbleiterbauteile 2, welche jeweils über das elektrisch leitende Material 7 elektrisch leitend kontaktiert sind.

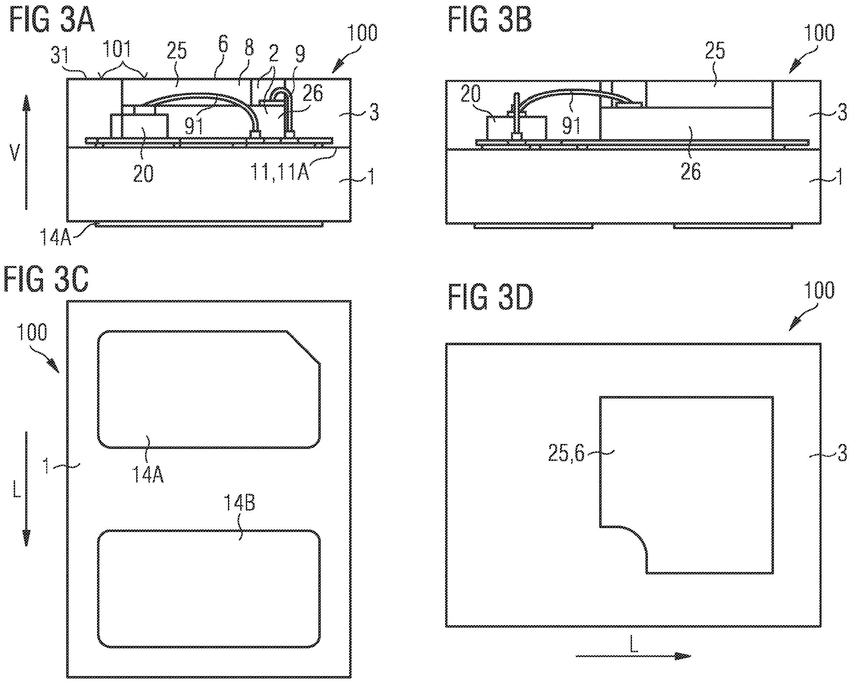

In den Figuren 3A bis 3D ist in schematischen Ansichten ein weiteres Ausführungsbeispiel eines hier beschriebenen optoelektronischen Halbleiterbauelements 100 dargestellt.

Die Figur 3A zeigt in einer schematischen Schnittdarstellung wie auf die Fläche 11A an der Oberseite 11 des Trägers 1 ein optoelektronisches Halbleiterbauteil 2 aufgebracht ist. Vorliegend ist das optoelektronische Halbleiterbauteil 2 mit einem strahlungsemittierenden Halbleiterchip 26 gebildet, wobei auf eine dem Träger 1 abgewandte Außenfläche des strahlungsemittierenden Halbleiterchips 26 ein Konversionselement 25 aufgebracht ist. Das Konversionselement 25 dient zur zumindest teilweisen Konversion von vom strahlungsemittierenden Halbleiterchip 26 emittierter elektromagnetischer Strahlung in elektromagnetische Strahlung eines anderen Wellenlängenbereichs. Die Seitenflächen 23 des strahlungsemittierenden Halbleiterbauteils 2 sind durch Seitenflächen des strahlungsemittierenden Halbleiterchips 26 und Seitenflächen des Konversionsbauteils 25 gebildet. Die Strahlungsaustrittsfläche 6 des Halbleiterbauteils 2 ist daher eine dem Träger 1 abgewandte Außenfläche des Konversionselements 25.

Im Unterschied zu dem in den Figuren 1A bis 1D dargestellten optoelektronischen Halbleiterbauelement 100 ist auf die strahlungsdurchlässige Schicht 4 verzichtet. Mit anderen Worten ist die Außenfläche 101 des optoelektronischen Halbleiterbauelements 100 vollständig durch die Außenfläche 31 der strahlungsabsorbierenden Schicht 3 und die Strahlungsaustrittsfläche 6 gebildet. Die strahlungsabsorbierende Schicht 3 überragt das Halbleiterbauteil 2 in vertikaler Richtung V nicht und schließt in lateraler Richtung L bündig mit der Strahlungsaustrittsfläche 6 des Halbleiterbauteils 2 ab. Weiter verläuft die Bonddrahtkontaktierung 9 vollständig innerhalb der strahlungsabsorbierenden Schicht 3 und ist von dieser umschlossen.

In der Figur 3B ist in einer weiteren schematischen Schnittdarstellung entlang der lateralen Richtung L das in der Figur 3A gezeigte optoelektronische Halbleiterbauelement 100 dargestellt. Erkennbar ist, dass ein elektronisches Bauteil 20 auf die Fläche 11A an der Oberseite 11 aufgebracht ist und elektrisch mittels einer weiteren Bonddrahtkontaktierung 91 mit dem strahlungsemittierenden Halbleiterchip 26 beispielsweise antiparallel verschaltet ist. Dabei ist das elektronische Bauteil 20 sowie die weitere Bonddrahtkontaktierung 91 vollständig von der strahlungsabsorbierenden Schicht 3 bedeckt. Mit anderen Worten ist das elektronische Bauteil 20 von außen nicht mehr erkennbar.

Die Figur 3C zeigt in einer schematischen Unteransicht auf der Fläche 12A das in den Figuren 3A und 3B beschriebene optoelektronische Halbleiterbauelement 100 mit seinen Kontaktflächen 14A und 14B.

Weiter ist in der Figur 3D in einer schematischen Draufsicht auf die Außenfläche 101 des optoelektronischen Halbleiterbauelements 100 erkennbar, dass bis auf die Strahlungsaustrittsfläche 6 der Rest der Außenfläche 101 schwarz erscheint. Mit anderen Worten erscheint in diesem Fall die Außenfläche 101 des Halbleiterbauelements 100 nur an Stellen des Konversionselements 25 farbig, da das Konversionselement 25 bei Bestrahlung mit Umgebungslicht farbiges Licht reemittieren kann.

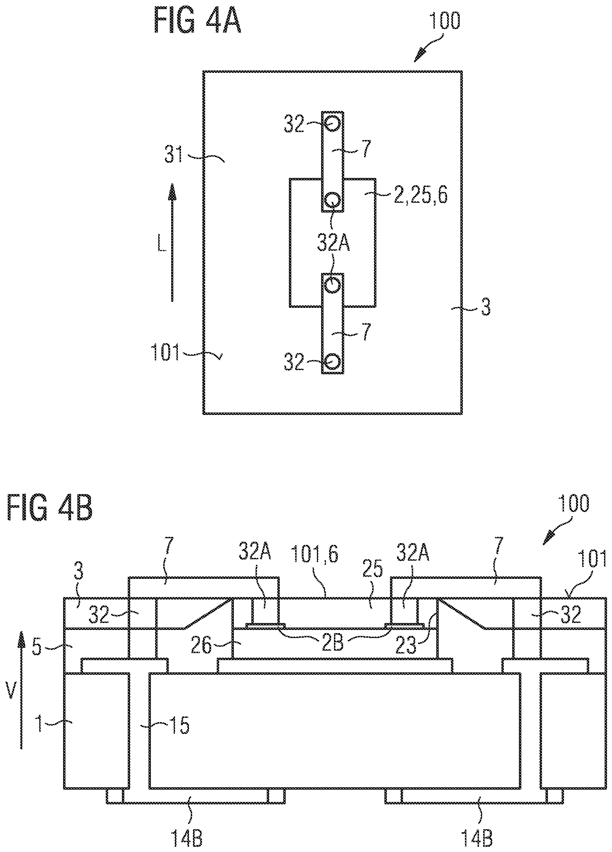

In den Figuren 4A und 4B ist in schematischen Ansichten ein weiteres Ausführungsbeispiel eines hier beschriebenen optoelektronischen Halbleiterbauelements 100 dargestellt.

Dabei ist aus der Figur 4A in der hier dargestellten schematischen Draufsicht auf die Außenfläche 101 des Halbleiterbauelements 100 erkennbar, dass die Außenfläche 101 durch die Außenfläche 31 der strahlungsabsorbierenden Schicht 3 und die Strahlungsaustrittsfläche 6 des strahlungsemittierenden Halbleiterbauteils 2 gebildet ist. Dabei ist die Strahlungsaustrittsfläche 6 wiederum durch die dem Träger 1 abgewandte Außenfläche des Konversionselements 25 gebildet. Allerdings ist im Unterschied zu den vorher dargestellten Ausführungsbeispielen statt der Bonddrahtkontaktierung 9 oder einer einzigen einem strahlungsemittierenden Halbleiterbauteil 2 zugeordneten Schichtöffnung 32 das strahlungsemittierende Halbleiterbauteil 2 mittels zweier in die strahlungsabsorbierende Schicht 3 eingebrachter weiterer Schichtöffnungen 32A elektrisch kontaktiert. Zur elektrischen Kontaktierung weist das strahlungsemittierende Halbleiterbauteil 2 zwei Kontaktflächen 2B auf, über denen die beiden weiteren Schichtöffnungen 32A in das Konversionselement 25 eingebracht sind. Weiter ist eine elektrisch leitende Verbindung jeweils zwischen einer Schichtöffnung 32 und einer der Schichtöffnung 32 zugeordneten weiteren Schichtöffnung 32A mittels des elektrisch leitenden Materials 7 hergestellt. Die Kontaktierung des strahlungsemittierenden Halbleiterbauteils 2 verläuft bis auf den obig dargestellten Unterschied in der gleichen Weise wie bei dem in den Figuren 2A bis 2E dargestellten Ausführungsbeispiel.

Aus der Figur 4B ist in der hier dargestellten schematischen Schnittansicht des optoelektronischen Halbleiterbauelements 100 erkennbar, dass in vertikaler Richtung V zwischen der strahlungsabsorbierenden Schicht 3 und dem Träger 1 eine strahlungsreflektierende Schicht 5 angeordnet ist. Die strahlungsreflektierende Schicht 5 bedeckt die Seitenflächen 23 des Halbleiterbauteils 2 stellenweise. Die nicht von der strahlungsreflektierenden Schicht 5 bedeckten Stellen der Seitenflächen 23 sind von der strahlungsabsorbierenden Schicht 3 bedeckt. Vorliegend treten zumindest 20 % der insgesamt von dem strahlungsemittierenden Halbleiterbauteil 2 emittierten elektromagnetischen Strahlung durch die Seitenflächen 23 aus dem strahlungsemittierenden Halbleiterbauteil 2 aus und werden durch die strahlungsreflektierende Schicht 5 zumindest teilweise zurück in das Halbleiterbauteil 2 reflektiert und beispielsweise in Richtung der Strahlungsaustrittsfläche 6 gelenkt. Mit anderen Worten handelt es sich bei dem in den Figuren 4A und 4B dargestellten Halbleiterbauteil 2 um einen Volumenemitter. Die Erfindung ist nicht durch die Beschreibungen anhand der Ausführungsbeispiele beschränkt. Vielmehr erfasst die Erfindung jede Kombination von Merkmalen wie beansprucht. Diese Patentanmeldung beansprucht die Priorität der deutschen Patentanmeldung 10 2010 046 254.3.

## Patentansprüche

1. Optoelektronisches Halbleiterbauelement (100), umfassend
- einen Träger (1), der eine Oberseite (11) und eine der Oberseite (11) gegenüberliegende Unterseite (12) aufweist;
- zumindest ein an der Oberseite (11) angeordnetes strahlungsemittierendes Halbleiterbauteil (2) mit einer Strahlungsaustrittsfläche (6), durch die zumindest ein Teil der im Betrieb des Halbleiterbauteils (2) erzeugten elektromagnetischen Strahlung das Halbleiterbauteil (2) verlässt, und
- eine strahlungsabsorbierende Schicht (3), die dazu eingerichtet ist, auf das Bauelement (100) auftreffendes Umgebungslicht derart zu absorbieren, dass eine dem Träger (1) abgewandte Außenfläche (101) des Bauelements (100) zumindest stellenweise schwarz erscheint, wobei
- die strahlungsabsorbierende Schicht (3) das strahlungsemittierende Halbleiterbauteil (2) in lateraler Richtung (L) vollständig umrandet, und
- die Strahlungsaustrittsfläche (6) frei von der strahlungsabsorbierenden Schicht (3) ist, wobei die Außenfläche (101) des Halbleiterbauelements zumindest stellenweise durch die Außenfläche (31) der strahlungsabsorbierenden Schicht (3) gebildet ist, wobei
- in vertikaler Richtung (V) zwischen dem Träger (1) und der strahlungsabsorbierenden Schicht (3) eine strahlungsreflektierende Schicht (5) angeordnet ist, welche die Seitenflächen des Halbleiterbauteils (2) stellenweise bedeckt,
**dadurch gekennzeichnet, dass**
- die strahlungsabsorbierende Schicht mit Seitenflächen des strahlungsemittierenden Halbleiterbauteils zumindest stellenweise in direktem Kontakt ist, und
- in einer Draufsicht auf die Außenfläche des Halbleiterbauelements (100) die strahlungsreflektierende Schicht (5) vollständig durch die strahlungsabsorbierende Schicht (3) verdeckt ist.

2. Optoelektronisches Halbleiterbauelement (100) nach dem vorhergehenden Anspruch,
bei dem die strahlungsabsorbierende Schicht (3) ein Verguss ist, der die Seitenflächen (23) des Halbleiterbauteils (2) zumindest stellenweise formschlüssig umhüllt.

3. Optoelektronisches Halbleiterbauelement (100) nach einem der vorhergehenden Ansprüche,
bei dem die strahlungsabsorbierende Schicht (3) das Halbleiterbauteil (2) in einer vertikalen Richtung (V) nicht überragt.

4. Optoelektronisches Halbleiterbauelement (100) nach einem der vorhergehenden Ansprüche,
bei dem zumindest 20 % der insgesamt von dem Halbleiterbauteil (2) emittierten elektromagnetischen Strahlung durch die Seitenflächen (23) aus dem Halbleiterbauteil (2) austreten und durch strahlungsreflektierende Schichten (5) zumindest teilweise reflektiert werden.

5. Optoelektronisches Halbleiterbauelement (100) nach einem der vorhergehenden Ansprüche,
bei dem auf eine dem Träger (1) abgewandte Außenfläche (31) der strahlungsabsorbierenden Schicht (3) und/oder auf die Strahlungsaustrittsfläche (6) zumindest stellenweise eine strahlungsdurchlässige Schicht (4) aufgebracht ist.

6. Optoelektronisches Halbleiterbauelement (100) nach einem der vorhergehenden Ansprüche, mit
- zumindest einer über zumindest einer Anschlussstelle (13) des Trägers (1) angeordnete Schichtöffnung (32), welche die strahlungsabsorbierende Schicht (3) vollständig durchdringt und sich von einer dem Träger (1) abgewandten Oberseite (31) der strahlungsabsorbierenden Schicht (3) in Richtung der Unterseite (12) des Trägers (1) erstreckt, wobei
- die Schichtöffnung (32) in lateraler Richtung (L) beabstandet zu dem Halbleiterbauteil (2) angeordnet ist,
- in der Schichtöffnung (32) zumindest stellenweise ein elektrisch leitendes Material (7) angeordnet ist,
- das elektrisch leitende Material (7) zumindest stellenweise auf der dem Träger (1) abgewandten Außenfläche (101) des Bauelements (100) angeordnet ist, und
- das elektrisch leitende Material (7) die Anschlussstelle (13) elektrisch leitend mit dem Halbleiterbauteil (2) verbindet.

7. Optoelektronisches Halbleiterbauelement (100) nach einem der vorhergehenden Ansprüche,
bei dem zumindest eine leitende Verbindung zwischen der Anschlussstellen (13) und einer weiteren Anschlussstelle (2A) an der Oberseite des Trägers (1) mit Kontaktflächen (14A, 14B) an der der Oberseite (11) gegenüberliegende Unterseite (12) des Trägers (1) mittels einer Durchkontaktierung (15) hergestellt ist.

8. **Optoelektronisches** Halbleiterbauelement (100) nach Anspruch 6, bei dem die Schichtöffnung (32) zusätzlich die strahlungsreflektierende Schicht (5) und/oder die strahlungsdurchlässige Schicht (4) vollständig durchdringt.

9. Optoelektronisches Halbleiterbauelement (100) nach einem der vorhergehenden Ansprüche,
bei der eine Bonddrahtkontaktierung (9) des Halbleiterbauteils (2) zumindest teilweise von der strahlungsabsorbierenden Schicht (3) bedeckt ist.

10. Optoelektronisches Halbleiterbauelement (100) nach Anspruch 6, bei dem das elektrisch leitende Material (7) stellenweise direkt an die strahlungsabsorbierende Schicht (3) grenzt.

11. Optoelektronisches Halbleiterbauelement (100) nach dem vorhergehenden Anspruch,
bei dem das elektrisch leitende Material (7) strahlungsdurchlässig, insbesondere klarsichtig und transparent, ist.

## Claims

1. An optoelectronic semiconductor device (100) comprising
- a support (1) having an upper side (11) and one of the upper side (11) opposite bottom (12);
- at least one on the upper side (11) arranged radiation-emitting semiconductor device (2) having a radiation exit surface (6) through which at least part of the electromagnetic radiation generated during operation of the semiconductor device (2) leaves the semiconductor device (2), and
- a radiation-absorbing layer (3) which is adapted to absorb ambient light impinging on the component (100) in such a way that an outer surface (101) of the component (100) facing away from the carrier (1) appears black at least in places,
- the radiation-absorbing layer (3) completely surrounds the radiation-emitting semiconductor component (2) in the lateral direction (L), and
- the radiation exit surface (6) is free of the radiation-absorbing layer (3), wherein
the outer surface (101) of the semiconductor device is formed at least in places by the outer surface (31) of the radiation-absorbing layer (3), wherein
- in the vertical direction (V) between the carrier (1) and the radiation-absorbing layer (3) a radiation-reflecting layer (5) is arranged, which covers the side surfaces of the semiconductor component (2) in places,
**characterized in that**
- the radiation-absorbing layer is at least locally in direct contact with side surfaces of the radiation-emitting semiconductor device, and
- in a plan view of the outer surface of the semiconductor device (100), the radiation-reflecting layer (5) is completely covered by the radiation-absorbing layer (3).

2. Optoelectronic semiconductor component (100) according to the preceding claim,
wherein the radiation-absorbing layer (3) is a potting, which encloses the side surfaces (23) of the semiconductor device (2) at least in places in a form-fitting manner.

3. Optoelectronic semiconductor component (100) according to one of the preceding claims,
wherein the radiation-absorbing layer (3) does not project beyond the semiconductor device (2) in a vertical direction (V) .

4. Optoelectronic semiconductor component (100) according to one of the preceding claims,
wherein at least 20% of the electromagnetic radiation emitted by the semiconductor device (2) emerges from the semiconductor device (2) through the side surfaces (23) and is at least partially reflected by radiation-reflecting layers (5).

5. Optoelectronic semiconductor component (100) according to one of the preceding claims,
wherein a radiation-transmissive layer (4) is applied at least in places on an outer surface (31) of the radiation-absorbing layer (3) facing away from the carrier (1) and / or on the radiation exit surface (6).

6. Optoelectronic semiconductor component (100) according to one of the preceding claims, with
- at least one layer opening (32) which is disposed over at least one connection point (13) of the carrier (1) and passes completely through the radiation-absorbing layer (3) and extends from an upper side (31) of the radiation-absorbing layer (3), facing away from the carrier (1), in the direction of the lower side (12) of the carrier (1), wherein
- the layer opening (32) is disposed in a lateral direction (L) spaced apart with respect to the semiconductor device (2),
- an electrically conductive material (7) is disposed, at least in places, in the layer opening (32),
- the electrically conductive material (7) is disposed, at least in places, on the outer surface (101) of the component (100) facing away from the carrier (1), and
- the electrically conductive material (7) connects the connection point (13) to the semiconductor device (2) in an electrically conductive manner.

7. Optoelectronic semiconductor component (100) according to one of the preceding claims, wherein at least one conductive connection is established between the connection point (13) and a further connection point (2A) on the upper side of the carrier (1) with contact surfaces (14A, 14B) on the lower side (12) of the carrier (1), opposite to the upper side (11), by means of an interlayer connection (15).

8. Optoelectronic semiconductor component (100) according to claim 6, wherein the layer opening (32) also passes completely through the radiation-reflecting layer (5) and/or the radiation-permeable layer (4).

9. Optoelectronic semiconductor component (100) according to one of the preceding claims, wherein a bond wire contacting (9) of the semiconductor device (2) is covered at least partially by the radiation-absorbing layer (3).

10. Optoelectronic semiconductor component (100) according to claim 6, wherein the electrically conductive material (7) directly adjoins the radiation-absorbing layer (3) in places.

11. Optoelectronic semiconductor component (100) according to the preceding claim, wherein the electrically conductive material (7) is radiation-permeable, in particular see-through and transparent.

## Revendications

1. Dispositif semi-conducteur optoélectronique (100) comprenant
- un support (1) qui présente un côté supérieur (11) et un côté inférieur (12) opposé au côté supérieur (11) ;
- au moins un composant semi-conducteur (2) émetteur de rayonnement, disposé sur le côté supérieur (11), comprenant une surface de sortie de rayonnement (6) à travers laquelle au moins une partie du rayonnement électromagnétique généré pendant le fonctionnement du composant semi-conducteur (2) quitte le composant semi-conducteur (2), et
- une couche (3) absorbant le rayonnement, laquelle est configurée pour absorber la lumière ambiante incident sur le dispositif (100), de manière à ce qu'une surface extérieure (101) du dispositif (100), détournée du support (1), apparaisse en noir au moins par endroits,
- la couche (3) absorbant le rayonnement bordant complètement en direction latérale (L) le composant semi-conducteur (2) émetteur de rayonnement, et
- la surface de sortie de rayonnement (6) étant exempte de la couche (3) absorbant le rayonnement,
- la surface extérieure (101) du dispositif semi-conducteur étant formée au moins par endroits par la surface extérieure (31) de la couche (3) absorbant le rayonnement,
- une couche (5) réfléchissant le rayonnement étant disposée en direction verticale (V) entre le support (1) et la couche (3) absorbant le rayonnement, laquelle recouvre par endroits les surfaces latérales du composant semi-conducteur (2),
**caractérisé en ce que**
- la couche absorbant le rayonnement est en contact direct au moins par endroits avec des surfaces latérales du composant semi-conducteur émetteur de rayonnement, et
- **en ce que** la couche (5) réfléchissant le rayonnement, dans une vue de dessus de la surface extérieure du dispositif semi-conducteur (100), est complètement recouverte par la couche (3) absorbant le rayonnement.

2. Dispositif semi-conducteur optoélectronique (100) selon la revendication précédente,
dans lequel la couche (3) absorbant le rayonnement est un enrobage enveloppant par adhérence de forme, au moins par endroits, les surfaces latérales (23) du composant semi-conducteur (2).

3. Dispositif semi-conducteur optoélectronique (100) selon l'une quelconque des revendications précédentes,
dans lequel la couche (3) absorbant le rayonnement ne dépasse pas le composant semi-conducteur (2) dans une direction verticale (V).

4. Dispositif semi-conducteur optoélectronique (100) selon l'une quelconque des revendications précédentes,
dans lequel au moins 20% du rayonnement électromagnétique émis au total par le composant semi-conducteur (2) sortent du composant semi-conducteur (2) par les surfaces latérales (23) et sont réfléchis au moins en partie par les couches (5) réfléchissant le rayonnement.

5. Dispositif semi-conducteur optoélectronique (100) selon l'une quelconque des revendications précédentes,
dans lequel une couche (4) perméable au rayonnement est appliquée au moins par endroits sur une surface extérieure (31) de la couche (3) absorbant le rayonnement, détournée du support (1), et/ou sur la surface de sortie de rayonnement (6) .

6. Dispositif semi-conducteur optoélectronique (100) selon l'une quelconque des revendications précédentes, comprenant
- au moins une ouverture de couche (32) disposée au-dessus d'au moins un point de connexion (13) du support (1), laquelle traverse complètement la couche (3) absorbant le rayonnement et s'étend d'un côté supérieur (31) de la couche (3) absorbant le rayonnement, détourné du support (1), en direction du côté inférieur (12) du support (1),
- l'ouverture de couche (32) étant disposée en direction latérale (L) à écart du composant semi-conducteur (2),
- une matière (7) électro-conductrice étant disposée au moins par endroits dans l'ouverture de couche (32),
- la matière (7) électro-conductrice étant disposée au moins par endroits sur la surface extérieure (101) du dispositif (100), détournée du support (1), et
- la matière (7) électro-conductrice reliant le point de connexion (13) au composant semi-conducteur (2) de manière électro-conductrice.

7. Dispositif semi-conducteur optoélectronique (100) selon l'une quelconque des revendications précédentes,
dans lequel au moins une liaison conductrice est établie entre les points de connexion (13) et un point de connexion supplémentaire (2A) sur le côté supérieur du support (1) aux surfaces de contact (14A, 14B) sur le côté inférieur (12) du support (1), opposé au côté supérieur (11), au moyen d'un via (15) .

8. Dispositif semi-conducteur optoélectronique (100) selon la revendication 6,
dans lequel l'ouverture de couche (32) traverse complètement, en outre, la couche (5) réfléchissant le rayonnement et/ou la couche (4) perméable au rayonnement.

9. Dispositif semi-conducteur optoélectronique (100) selon l'une quelconque des revendications précédentes,
dans lequel une connexion par fil de connexion (9) du composant semi-conducteur (2) est recouverte au moins en partie par la couche (3) absorbant le rayonnement.

10. Dispositif semi-conducteur optoélectronique (100) selon la revendication 6,
dans lequel la matière (7) électro-conductrice est directement adjacente à la couche (3) absorbant le rayonnement.

11. Dispositif semi-conducteur optoélectronique (100) selon la revendication précédente,
dans lequel la matière (7) électro-conductrice est perméable au rayonnement, notamment translucide et transparente.
